# EUROPEAN PATENT APPLICATION

(11) **EP 1 245 528 A1**
(43) Date of publication of application: **02.10.2002**
(21) Application number: 01610035.6
(22) Date of filing: 27.03.2001
(51) Int. Cl.: B81B 3/00, B81B 7/00, G02B 6/42, B01L 3/00

(54) **A unitary flexible microsystem and a method for producing same**

(71) Applicant: Delta Danish Electronics, Light & Acoustics, 2970 Horsholm (DK)
(72) Inventor: Lisby, Torben, 2400 Copenhagen NV (DK); Branebjerg, Jens A., 2970 Horsholm (DK)
(74) Representative: Nielsen, Henrik Sten

(57) **Abstract**

The present invention relates to microsystems having flexibility properties so as to enable folding of the microsystem in any three-dimensional direction. That is, enabling torsional and three-dimensionally non-linearly bending of the microsystem. The present invention provides a flexible three-dimensional microsystem compatible with hostile environments such as encountered within a biological body. In particular, provides a bio-compatible three-dimensional microsystem operational in hostile environments while biological acceptable to biological bodies. The present invention further provides an overall stress stability since forming a unitary structure eliminating stress induced or caused by joining various parts of different materials having different material properties into an assembly.

## Description

The present invention relates to the technical field of miniaturisation of systems in particular to microsystems having flexibility properties so as to enable the microsystem to fold the microsystem in any three-dimensional direction.

The prior art techniques includes methods for producing a flexible silicon bar as described in "Mechanical characterisation of flexible silicon microstructures" published for the 14^{th} European Conference on Solid-State Transducers, in Copenhagen, Denmark, August 27-30, 2000 and written by T. Lisby, S. Nikles, K. Najafi, S. Bouwstra and J. Branebjerg. This article describes a fabrication of flexible microstructures using a silicon wafer subjected to shallow boron diffusion to a depth of approximately 3 µm. The boron doped region serves to control the thickness of the flexible microstructure by defining the amount of base material to be etched away in an alkaline solution. The thin boron doped region provides flexibility of the final microstructure. The article further describes examples of various configurations of the flexible microstructures mechanically tested so as to assure a high mechanical stability. The article, however, fails to provide any means for fabricating microstructures to be applied in any particular system, such as a highly corrosive environment like an alkaline solution.

A further article entitled "A Low-Power Wireless Microinstrumentation System for Environmental Monitoring", published for the 8^{th} International Conference on Solid-State Sensors and Actuators, and Eurosensors IX, in Stockholm, Sweden, June 25-29, 1985, and written by Andrew Mason, Navid Yazdi, Khalil Najafi, and Kensall D. Wise. This article describes a microsystem containing sensors for measuring temperature, barometric pressure, altitude, humidity and acceleration. The application of several micro-machined silicon platforms connected by gold-plated silicon ribbon cables enables folding of the microsystem so as to accomplish a reduction in overall volume. The system described uses a bulky housing to protect the system from the surrounding environment. Hence further miniaturisation is necessary so as to provide a compact and protected system.

A further an article entitled "Flexible Silicon Structures for a Retina Implant", published in IEEE 0-7803-4412-X/98/$10.00, 1998, and written by H.K. Trieu, L. Ewe, W. Mokwa, M. Schwarz, and B.J. Hosticka. This article presents an epiretinal implant system with emphasis on the retina stimulator, which differs significantly from other approaches by using flexible single-crystal silicon. Electronic components are integrated in compact parts of rigid silicon, which are connected mechanically by flexible silicon crosspieces that form bridges. A single-crystal silicon wafer is subjected to silicon epitaxial deposition on a buried silicon oxide layer and the final thickness of the epitaxial deposition layer determines the thickness of the flexible silicon crosspieces i.e. the flexible silicon crosspieces are constituted by the epitaxial deposition layer. The article, however, fails to show how to protect the silicon structures when submitted to a harsh environment. The substrate is entirely used for determining thickness and not as an active material.

A similar approach is found in an article entitled "High Density Thin Film Flexible Interconnector", published for the ICEMCM conference 1996 as ICEMCM' 96 proceedings, and written by Michael Peters, William Chou, Michael G. Lee, Vivek Mansingh, and Solomon Beilin. This article describes an interconnect combining high routing density of thin film MCMs with a flexible structure that allows arbitrary orientation to each other. The flexible structure is accomplished by depositing a firstly a silicon oxide layer to the surfaces of a silicon or a molybdenum substrate, secondly a polyimide layer, and thirdly metallic thin film structure. The flexibility is of the flexible structure is achieved by etching away the silicon or molybdenum substrate, thus the flexible structure is entirely constituted by the polyimide layer and the metallic thin film layer. The polyimide layer provides the flexibility of the flexible structure, however, matching physical properties of a particular polyimide to the physical properties to the substrate is extremely complicated. Further, the use of polyimide excludes the possibility of integrating functionality in the substrate, thus the flexible structure may not be utilised for incorporation of circuit elements.

Additionally, an article entitled "Flexible Silicon Interconnects for Microelectromechanical Systems", published in IEEE 91CH2817-5/91/0000-076401.00 in 1991, and written by J.F. Hetke, K. Najafi, and K.D. Wise. This article describes a structure for shielded flexible silicon cables for applications in biomedicine including long-term implantation of miniature pressure sensors intracranially or in the cardiovascular system or as floating electrode arrays for recording and stimulation in the central nervous system. Further the shielded flexible silicon cables may be incorporated in micro electro-mechanical systems for delivering power and data to moveable parts. The fabrication of the shielded flexible silicon cables involves deep and shallow boron diffusion. The deep boron diffusion is applied in areas, which are used as pad areas, and the shallow boron diffusion is applied to the area, where the flexible silicon cables are. The flexible silicon cables are thus constituted from the wafer material and the thickness of the flexible silicon cables is determined by the shallow boron diffusion. The article, however, fails to describe how the contact region between the silicon cable and the individual parts should be protected if the cables are used in micro-electro-mechanical systems (MEMS) subjected to a corroding environment. The method described dissolves the rest of the original wafer so the individual cables no longer can be handled on a wafer level.

An object of the present invention is to provide a flexible three-dimensional microsystem foldable in all directions. That is to enable torsional and three-dimensionally non-linearly bending of the microsystem.

An additional object of the present invention is to provide a flexible three-dimensional microsystem, which is compatible with hostile environments such as encountered within a biological body. In particular, to provide a bio-compatible three-dimensional microsystem operational in hostile environments while biological acceptable to biological bodies.

A particular advantage of this invention is the provision of means for miniaturisation of microsystems by folding individual elements about each other so as to reduce size of the overall microsystem and simultaneously maintaining mechanical and chemical robustness.

A particular feature of this invention is the overall stress stability of a microsystem since forming a unitary structure. The unitary structure eliminates stress induced or caused by joining various parts of different materials having different material properties into an assembly.

The above described objects, advantage and feature together with numerous other objects, advantages and features of the present invention which will be evident from below description of preferred embodiments of the present invention are according to a first aspect of the invention obtained by a method for producing a unitary flexible microelement from a supporting wafer, said unitary flexible microelement defining a supporting body having a solid region, a flexible region, an upper surface and a lower surface, and said method comprising the following steps of:
(a) defining thickness of said flexible region,
(b) growing an upper insulating layer to said upper surface substantially covering said predefined area and growing a lower insulating layer to said lower surface substantially covering said solid region so as to protect said solid region of said supporting body against etching,
(c) defining a conductive layer on said predefined area of said upper surface, and depositing a protective layer on said upper surface covering said conductive layer so as to protect said conductive layer against etching, and
(d) etching said lower surface until said etching reaches said thickness of said flexible region so as to establish said flexible region and to establish said solid region.

According to the basic realisation of the present invention according to the first aspect the method utilises techniques of producing electronic circuits' in particular involving planar technique as the microelement is produced from a supporting body originating from a wafer body. The unitary structure of the microelement ensures a robust structure since an overall stress compatibility between elements of the microelement is achieved.

The wafer may be a non-conducting ceramic or a semiconducting material, where the semiconducting material may be Germanium (Ge), Silicon (Si) or combinations hereof and may be in the form of a semiconductor wafer structure or a semiconductor wafer structure having a single crystal silicon on insulator (SOI).

The step of defining the thickness of the flexible region may comprise doping the supporting body through a predefined area of the upper surface by diffusing impurity atoms until the impurity atoms reaches a predefined distance between the upper surface and the lower surface, the predefined distance substantially equalling the thickness of the flexible region. The impurity atoms may be diffused utilising boron nitride sources in an oven at a temperature at 1100° C for some few hours until a boron content higher than 5x10¹⁹ atoms/cm³ to obtain 1 to 10 µm deep doped regions. Thus doping of the supporting body is accomplished utilising boron diffusion techniques.

Alternatively, the step of defining the thickness of the flexible region may comprise implanting impurity atoms at a high energy, the impurity atoms subsequently diffuse until they reach a predefined distance between the upper surface and the lower surface.

Further alternatively, the step of defining the thickness of the flexible region may comprise diffusing phosphorous atoms into a p-type substrate so as to establish a pn junction which under forward bias will stop the etching when it reaches the n layer, the pn junction may be established at a predefined distance between the upper surface and the lower surface.

Further alternatively, the step of defining of the thickness of the flexible region may comprise utilising a layered wafer incorporating an insulator layer at a predefined distance between the upper surface and lower surface, the predefined distance substantially equalling the thickness of the flexible region.

Further alternatively, the step of defining of the thickness of the flexible region may comprise visually determining when the etching of lower surface reaches a predefined distance equalling the thickness of the flexible region.

Any of the above five alternative methods of determining the predefined distance or rather thickness of the flexible region of the microelement are conveniently integrated in the method according to the first aspect of the present invention. The thickness of the flexible region, that is, the predefined distance determines flexibility of the flexible region of the supporting body and the predefined distance is in a range between 1 and 10 µm such as ranges 2 and 8 µm, 4 and 6 µm, or such as ranges 1 and 3 µm, 3 and 6 µm, or 6 and 10 µm. The smaller the predefined distance the higher flexibility is achieved thus allowing for any particular flexibility to be established.

The upper insulating layer and the lower insulating layer according to the first aspect of the present invention each may comprise an inner silicon oxide layer and an outer silicon nitride layer. The inner silicon oxide layer may have a thickness in the range between 1 and 5 µm, preferably 3000 Å, and the silicon nitride layer may have a thickness in the range between 1 and 5000 Å, preferably 1200 Å. The silicon nitride layers are grown utilising a low-pressure chemical vapour deposition process (LPCVD). The upper insulating layer and the lower insulating layer provide a dielectric layer protecting the doped region of the microelement and protecting the solid regions to be defined during a later etching process. The thickness of the inner silicon oxide layer and the silicon nitride layers may be implemented in accordance with any electrically design or customer requirements.

The conductive layer according to the first aspect of the invention may enable fluid, optical, mechanical or electrical communication or any combination thereof across the flexible region. By implementing fluid guiding means on the upper surface of the flexible region communication is allowed between either end of the flexible region. This is particularly advantageous in microsystem delivering a dosage of fluids from one medium to another medium. By implementing optical guiding means on the upper surface of the flexible region optical communication is allowed between elements on either side of the flexible region. This is particularly advantageous in microsystems utilising optical circuitry.

Further actuation of the flexible region can be realized by introducing resistive heaters and use materials with different thermal expansion coefficients or by using electrostatic forces through an air-gap to an underlying material.. This is particularly advantageous in microsystems utilising the flexible regions as actuators.

The optical guiding means may be defined in the silicon oxide layer and the fluidic guiding means may be implemented by defining recesses in the silicon substrate and use the dielectric layer or the subsequent protective layer as capsule.

The conductive layer may further comprise any of the conductive materials Au, Ag, Pt, Ni, Ta, Ti, Cr, Cu, Os, W, Mo, Ir, Pd, Cd, Re, conductive diamond, metal silicides, doped polysilicon or any combinations thereof for enabling electrical communication across the flexible region. The choice of conductive materials should be determined in accordance with the application implemented as a microelement. The metals can be achieved by electrochemical deposition or evaporation or sputtering. If the conductive layer is a nonoxidizing metal an adhesion layer of an non oxidizing metal has to be deposited before the deposition of the conductive metal. If the metal is electrochemical deposited a further non oxidizing metal has to be deposited.
The adhesion layer according to the first aspect of the present invention may comprise a chromium (Cr) layer and a gold (Au) layer. The chromium layer may have a thickness in the range between 50 to 150 Å, preferably 100 Å, and the gold layer may have a thickness in the range between 500 and 4000 Å, preferably 1000 Å. Any oxide forming metal may in fact be used as the first layer, however, chromium is particular advantageous since it is resistant to KOH, and any electrochemical depositable metal may be used as the second, however, gold is advantageous since it forms no natural oxide layer.

The first aspect of the present invention allows for any customer requirements to be implemented or any circuitry requirements to be evaluated for the determination of choice of conductive materials.

The protective layer according to the first aspect of the present invention may comprise nickel (Ni) electroplated on the upper surface. Electroplating nickel on the upper surface provides protection of the microelement during a later etching process and may act as an environmental barrier in the final structure. The etching may be accomplished by utilising potassium hydroxide to etch areas of the supporting body not protected by the protective layer or by the lower insulating layer. The etching ceases as the etching reaches the flexible region.

By leaving the protective layer as an environmental barrier in the final structure the protective layer may provide a protection of the final structure against corrosion of the final structure, and further may provide protection against any depositing of hazardous materials on the outer surfaces of the final structure, which materials may short circuit or disrupt communication lines on the final structure.

The solid region according to the first aspect of the present invention may comprise a range of solid sections and wherein the flexible region may comprise a range of flexible sections interconnecting the solid sections so as to establish a unitary flexible microsystem. Further each of the range of solid sections may carry application specific integrated circuits (ASIC), integrated circuits, transducers, sensors, power units, actuators, micro electro-mechanical systems (MEMS) or any combination thereof. The conductive layer may comprise a plurality of conducting leads and the flexible region may comprise a plurality of flexible elements each supporting a conductive lead of the plurality of conductive leads.

The plurality of flexible elements according to the first aspect of the present invention are configured in parallel relative to each other, in parallel meandering fashion between distal ends of the plurality of flexible element relative to each other, in parallel partly meandering fashion at the distal ends of the plurality of flexible elements relative to each other, and/or in non parallel curving between distal ends of the plurality of flexible elements. The alternative configurations of the flexible elements provide any desired flexibility of application of a microelement thus certain configurations of the flexible elements give high flexibility in certain directions, while other configurations of the flexible elements give high flexibility in other directions.

The etching and the depositing according to the first aspect of the present invention may be controlled by utilising a photo resist mask defining areas to be exposed to the etching and to the depositing. A wet oxidation process and/or a chemical vapour deposition process may accomplish the growing of the insulating layer.

The method according to the first aspect of the present invention may further comprise depositing a conform coating layer surrounding the entire unitary flexible microelement so as to provide a bio-compatible protective layer. The conform coating of the microelement achieves bio-compatibility of the microelement that is to be construed as compatibility between the microelement and a biological body.

The term bio-compatibility should in this context be construed as compatibility between a biological body and an operational entity inserted in the biological body such as the above describe microelement. The compatibilityshould be construed as bi-directional, that is, the biological body should not be exposed to biological or pharmaceutical unacceptable entities and the operational entity should not be contaminated by the biological body e.g. electrically, magnetically, chemically or otherwise.

Finally the method according to the first aspect of the present invention may be undertaken at wafer level. The general wafer production techniques may be utilised for implementation of the flexibility of a microelement and further may be utilised for implementation of circuitry carried by the microelement. Thus great production advantages are achieved and a high degree of repeatability of the microelement production obtained. In particular, the wafer production techniques may be utilised for implementing circuitry and for coating the microelement, while the microelement is on the wafer. This highly increases the precision and the repeatability of the production.

The above described objects, advantages and features together with numerous other objects, advantages and features of the present invention which will be evident from below description of preferred embodiments of the present invention are according to a second aspect of the invention obtained by an unitary flexible microelement foldable in three-dimensional directions and comprising:
(a) a supporting body defining a first solid region and a flexible region extending outwardly in coplanar relationship from said solid region from upper surface of said supporting body,
(b) an first insulating layer grown on said upper surface of said supporting body,
(c) a conductive layer deposited on said insulating layer and communicating between said solid region and said flexible region,
(d) an second insulating layer deposited on said conductive lead insulating said conductive lead from surroundings, and
(e) pads connecting to distally positions of said conductive layer, said pads accessible through said second insulating layer from surroundings.

According to the basic realisation of the unitary flexible microelement according to second aspect of the present invention the supporting body may be a non-conducting ceramic or a semiconducting material, where the semiconducting material is Germanium (Ge), Silicon (Si) or combinations hereof and may be in the form of a semiconductor wafer structure or a semiconductor wafer structure having a single crystal silicon on insulator (SOI). By implementing the supporting body in a semiconducting materials such as Germanium or Silicon particular design advantages are achieved as described above with reference to the first aspect of the present invention regarding utilisation of general wafer production techniques.

The unitary flexible microelement according to the second aspect of the present invention may further comprise a second solid region integrally connecting to the first solid region through distal end of the flexible region in coplanar relationship the first solid body and the flexible region. The further second solid region may carry further circuitry communicating with circuitry situated on the first solid region. Thus the first and second solid regions being interconnected by the flexible regions enables the folding of the microelement about the flexible element hence reducing the size. The coplanar relationship between the solid regions and the flexible regions provide a smooth surface easy to cover with a protective layer without enduring covering problems at edges or corners.

The flexible region may comprise a plurality of independent flexible sections and wherein the conductive layer comprising a plurality of independent conductive leads, each of the plurality of independent flexible section supporting a conductive lead of the plurality of conductive leads.

The flexible region according to the second aspect of the present invention may be configured as a strait single bar, a strait single bar having rounded edges, a strait single bar having merging edges at areas connecting to the first and second solid regions, a strait single bar having merging edges at areas connecting to the first and second solid regions and round edges, and a meandering single bar. Each configuration provides for a particular flexibility thus the selecting configuration of the flexible region is accomplished in accordance with a particular application requiring a particular flexibility.

The flexible plurality of independent flexible sections according to the second aspect of the present invention may be configured as a plurality of parallel bars, which bars are strait, meandering or semi-meandering, or are configured as a plurality of individually curving bars having outer most positioned bars curving more than inner most positioned bares. Similarly, as described above selecting particular configuration provides for particular flexibility.

The unitary flexible microelement according to the second aspect of the present invention may further comprise circuitry connecting to the pads and positioned above the first and/or second solid regions. The circuitry may be implemented as application specific integrated circuits, integrated circuits, sensors, actuators, tranducers, micro electro-mechanical systems (MEMS) or combinations thereof. The particular implementation of the microelement on semiconducting wafers enables the high accuracy of circuitry to be directly implemented during one coherent process thus implement circuit element directly during the fabrication of the microelement or subsequently to the fabrication of the microelement. Further, by implementing circuitry directly on to the microelement an improved connection is established and additionally the mechanical strength is increased.

Further, the circuitry may be flip chip bonded and protected by an underfill positioned between the flip chip circuitry and the upper surface of the supporting body so as to provide protection against deterioration and/or wire bonded to the pads. In combination with the protective layer the underfill establishes a significant protection against diffusion in a direction parallel with the upper surface and in a direction perpendicular with the upper surface.

The unitary flexible microelement according to the second aspect of the present invention may further comprise studs positioned on the pads so as to provide a mounting connection from exterior circuitry to the pads. Additionally the unitary flexible microelement may comprise a feed through channel communicating between the upper surface of the supporting body to a lower surface of the supporting body. The feed through channel may connect the pads on the upper surface and pads on the lower surface.

The unitary flexible microelement according to the second aspect of the present invention may further comprise a conform coating layer surrounding the entire unitary flexible microelement so as to provide a bio-compatible protective layer. The conform coating provides bio-compatibility between the surrounding environment and the microelement. Thus the surrounding environment is prevented in transmitting any diffusing material to the microelement and further prevented in transmitting any electric, magnetic noise to the microelement and the microelement is prevented in transmitting diffusing material to the surrounding material and further prevented in transmitting any unintentional electric, magnetic noise to the surroundings. The bio-compatibility is particularly relevant in situations where the microelement is operated into a human or animal.

Finally, the unitary microelement is produced from method according to the first aspect of the present invention and the unitary microelement incorporates any features described with reference to the first aspect of the present invention.

The above described objects, advantages and features together with numerous other objects, advantages and features of the present invention which will be evident from below description of preferred embodiments of the present invention are according to a third aspect of the invention obtained by an unitary flexible microsystem foldable in three-dimensional directions and comprising:
(a) a supporting body defining a first plurality of solid regions and a second plurality of flexible regions integrally connecting in coplanar relationship said first plurality of solid regions,
(b) a third plurality of conductive leads positioned on said second plurality of flexible regions and connecting said first plurality of solid regions,
(c) a fourth plurality of pads distally positioned on each of said third plurality of conductive leads and having a stud positioned above each of said fourth plurality of pads,
(d) a fifth plurality of circuitry positioned on said first plurality of solid regions connecting to said fourth plurality of pads.

The term circuitry should in this context be construed as application specific integrated circuits, integrated circuits, general electronic components, sensors, actuators, tranducers, micro electro-mechanical systems (MEMS) or combinations thereof.

The unitary flexible microsystem according to the third aspect of the present invention may be manufactured at wafer level by a method as described with reference to the first aspect of the present invention. Thus the entire microsystem may be manufactured at wafer level so as to achieve significant production advantageous such as great repeatability.

The unitary flexible microsystem according to the third aspect of the present invention incorporates any features described with reference to a method according to the first aspect of the present invention and incorporates any features described with reference to a unitary flexible microelement according to the second aspect of the present invention.

The above described objects, advantages and features together with numerous other objects, advantages and features of the present invention which will be evident from below description of preferred embodiments of the present invention are according to a fourth aspect of the invention obtained by a unitary mechanical stress-decoupling system comprising a rigid frame, a rigid element, a plurality of flexible beams integrally connecting said rigid frame and said rigid element so as to provide a stress-decoupling between said rigid frame and said rigid element.

The plurality of flexible beams according to the fourth aspect of the present invention may define a conductive layer for enabling communication between the rigid frame and the rigid element. Further, the system may be produced utilising a method as described with reference to the first aspect of the present invention.

The unitary mechanical stress-decoupling system according to the fourth aspect of the present invention incorporates any features described with reference to a method according to the first aspect of the present invention, incorporates any features described with reference to a unitary flexible microelement according to the second aspect of the present invention, and incorporates any features described with reference to an unitary flexible microsystem according to the third aspect of the present invention.

The above described objects, advantages and features together with numerous other objects, advantages and features of the present invention which will be evident from below description of preferred embodiments of the present invention are according to a fifth aspect of the invention obtained by a unitary aligning module for aligning a first optical wave-guide and a second optical wave-guide and comprising a substrate supporting an unitary flexible microelement comprising a supporting body defining a first solid region and a flexible region extending outwardly in coplanar relationship from said solid region from upper surface of said supporting body and said unitary flexible microelement supporting said first optical wave-guide, and said substrate further supporting a deflection actuator having an upper surface supporting said second optical wave-guide and said deflection actuator controlling deflection of said flexible region so as to position said first optical wave-guide and said second optical wave-guide in alignment.

The deflection actuator according to the fifth aspect of the present invention may generate an electro-static, an electro-magnetic or a magnetic force for deflecting the flexible region. Further, the unitary flexible microelement further may comprise a conductive layer connecting to a resistor providing a thermal actuation of the flexible region.

The unitary aligning module according to the fifth aspect of the present invention incorporates any features described with reference to a method according to the first aspect of the present invention, incorporates any features described with reference to a unitary flexible microelement according to the second aspect of the present invention, incorporates any features described with reference to an unitary flexible microsystem according to the third aspect of the present invention, and incorporates any features described with reference to an unitary mechanical stress-decoupling system according to the fourth aspect of the present invention.

The above described objects, advantages and features together with numerous other objects, advantages and features of the present invention which will be evident from below description of preferred embodiments of the present invention are according to a sixth aspect of the invention obtained by a unitary flexible microelement for communicating fluid and comprising a first rigid part defining a first input passage and a first output passage communicating the fluid, a second rigid part defining a second input passage and a second output passage communicating the fluid, a flexible part interconnecting the first rigid part and the second rigid part and having a channel receiving the fluid from the first output passage and transporting the fluid to the second input passage, and a protective layer covering at least parts of upper surface of the unitary flexible microelement.

The unitary flexible microelement according to the sixth aspect of the present invention may preferably be manufactured at wafer level in accordance with the method according to the first aspect of the present invention. Thus the unitary flexible microelement may be manufactured during a single manufacturing process, which has superior repeatability. Furthermore, by coating the unitary flexible microelement with a bio-compatible coating the microelement may be used for medical appliances.

The first rigid part according to the sixth aspect of the present invention may further comprise a plurality of first input passages for receiving a plurality of fluids and a first plurality of output passages. The flexible part may further comprise a plurality of channels connecting to each of the plurality of first output passages so as to communicate the plurality of fluids to the second rigid part. The second rigid part may further comprise a plurality of second input passages receiving the plurality of fluids from the first rigid part, a channel mixer section connecting the plurality of second input passages mixing the plurality of fluids so as to generate a mixed fluid, and a plurality of second output passages ejecting the mixed fluid.

The unitary flexible microelement according to the sixth aspect of the present invention incorporates any features described with reference to a method according to the first aspect of the present invention, incorporates any features described with reference to a unitary flexible microelement according to the second aspect of the present invention, incorporates any features described with reference to an unitary flexible microsystem according to the third aspect of the present invention, incorporates any features described with reference to an unitary mechanical stress-decoupling system according to the fourth aspect of the present invention, and incorporates any features described with reference to an unitary aligning module according to the fifth aspect of the present invention.

### Brief description of the drawings

Figure 1, shows a wafer comprising a series of flexible elements.
Figure 2, shows two individual flexible elements.
Figure 3a through 3m, show production steps employed in obtaining a flexible element utilising Boron diffusion.
Figures 4a through 4k, show production steps employed in obtaining a flexible element utilising reactive ion etch from a silicon on insulator substrate.
Figures 5a through 5c, show in three views a flexible element comprising conductive leads.
Figures 6a through 6j, show a multiplicity of embodiments of flexible sections connecting rigid regions.
Figure 7, shows a first example of an utilisation of a flexible element connecting rigid regions mounted onto separate planes of a unit.
Figure 8, shows a second example of an utilisation of a flexible element connecting rigid regions mounted on the same plane of a unit.
Figure 9a and 9b show examples of a circuit element comprising a first section including a flip chip bonded die and a second section including a wire-bonded die.
Figure 10, shows an example of an utilisation of flexible elements enabling bending of a microsystem.
Figure 11 shows a second example of an utilisation of flexible elements provided in a mechanical stress-decoupling set-up.
Figures 12a and 12b show a third example of an utilisation of flexible elements provided in an aligning module.
Figures 13a and 13b show a fourth example of an utilisation of flexible elements provided in a flexible structure communicating fluids between to rigid sections.

### Detailed description of the present invention

The invention will below be described in further detail with reference to the above listed figures.

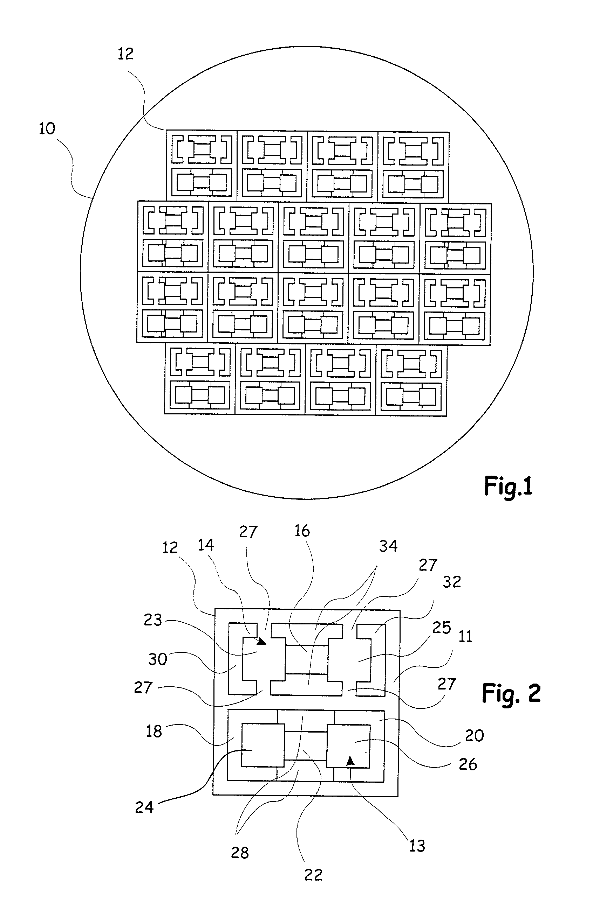

Figure 1, shows an example of wafer designated in its entirety by reference numeral 10 and comprising a plurality of framed flexible elements 12. The material of the wafer 10 may comprise any ceramic materials or semiconducting materials such as germanium Ge, silicon Si or combinations thereof. By utilising Ge, Si or combinations thereof firstly advantageously enables the possibility of applying integrated circuit fabrication technology hence benefiting from the micro-fabrication technology as such, in particular miniaturisation and repeatability in production. Secondly the use of the materials Ge, Si or combinations thereof enables the possibility of implementing circuit elements, e.g. application specific integrated circuits ASIC, sensor elements, actuator elements, transducer elements, micro electro mechanical systems (MEMS), or other three-dimensional microsystems, and the flexible elements during the same manufacturing process and further enables circuit elements, sensor elements, actuator elements, transducer elements, micro electro mechanical systems (MEMS), and/or other three-dimensional microsystems to be connected subsequently to the flexible element manufacturing process applying wafer scale apparatus.

The wafer 10 may have a thickness in the range from 100 to 700 µm, preferably in the range 300 to 700 µm. However thinner regions may be implemented.

Figure 2, shows an example of two framed flexible elements designated in their entirety by reference numeral 12 and shown as one of the plurality of flexible elements in figure 1. The two framed flexible elements 12 comprise a rigid region constituting a frame 11 surrounding both flexible elements designated by reference numeral 13 and 14. Each of the two flexible elements 13, 14 per se comprise a plurality of flexible sections 16,18, 20 and 22 and comprise rigid regions or pads designated by reference numerals 23, 24, 25 and 26.

The flexible elements 13 and 14 may be fixed to the frame 11 in a wide variety of ways. In figure 2 the flexible element 14 is connected to the frame 11 by thin rigid bridges all designated by reference numeral 27 and the flexible element 13 is connected to the frame 11 by thin flexible sections 18 and 20. Further, the flexible elements 13 and 14 comprise perforations 28, 30, 32 and 34. These perforations 28, 30, 32 and 34 ensure an easy separation of flexible elements 13 and 14 from the frame 11.

Once separated from the frame 11 the flexible sections 16 and 22 allow three-dimensional flexibility so as to ensure that the flexible sections 16 and 22 may connect circuit elements positioned at various angles relative to each other.

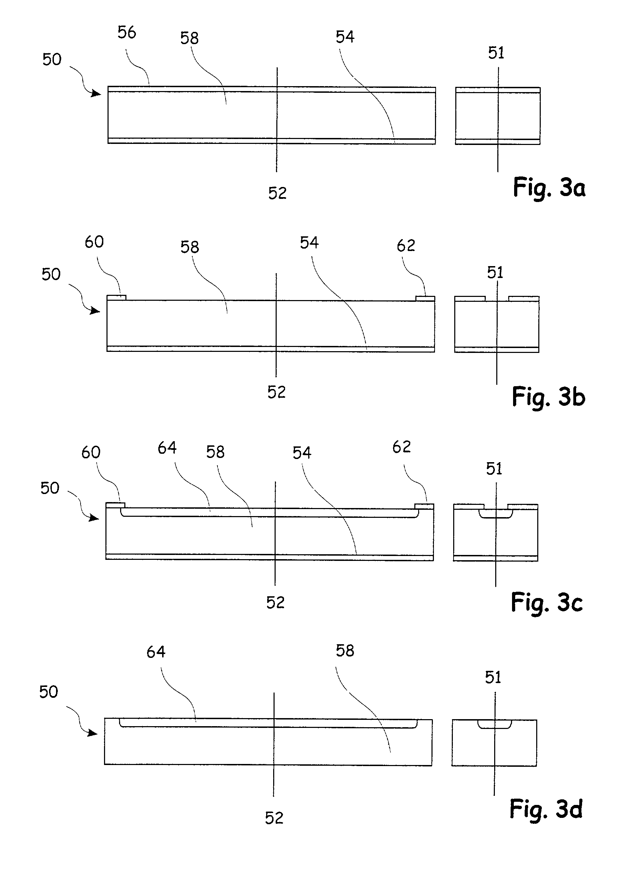

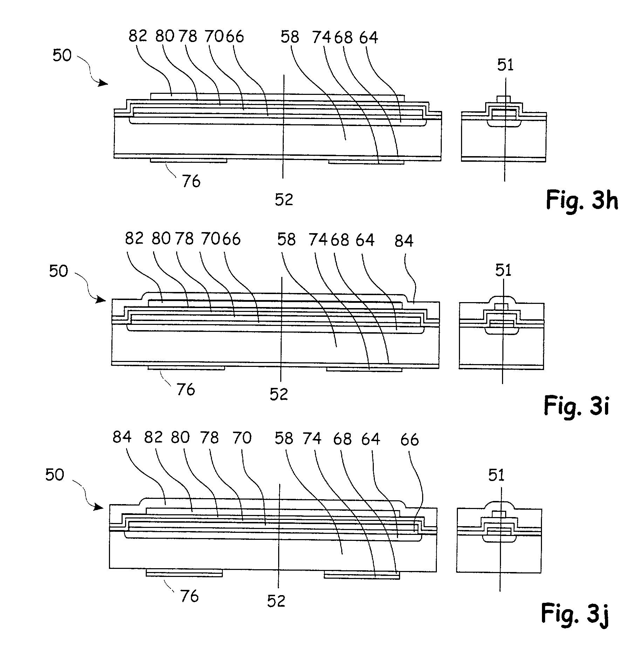

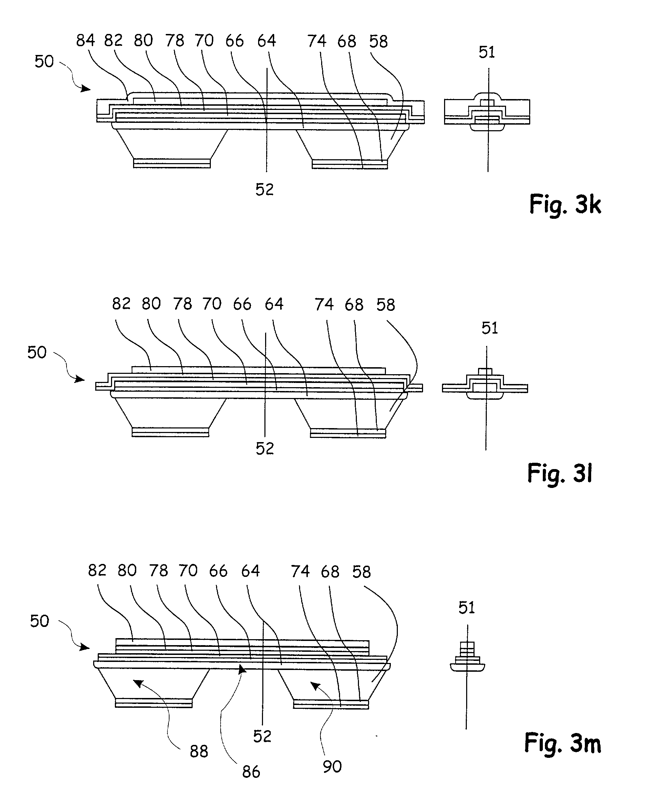

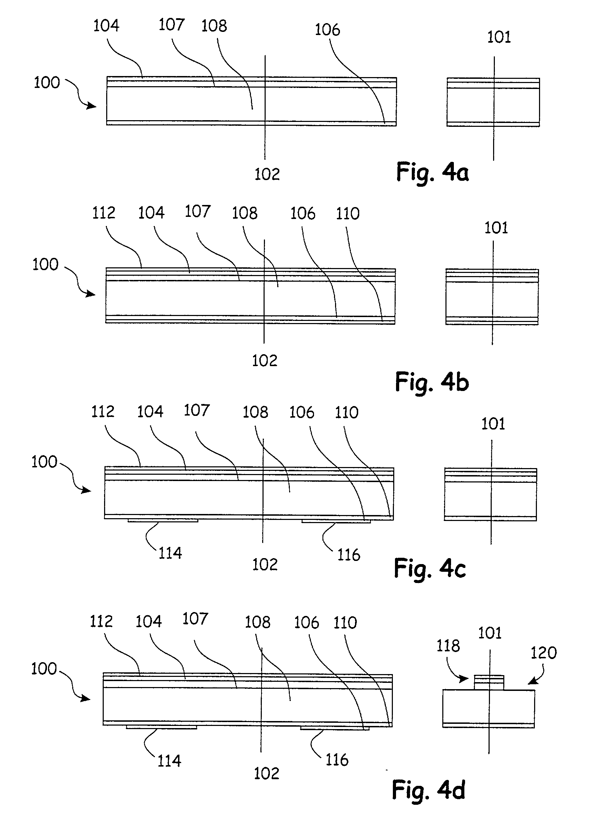

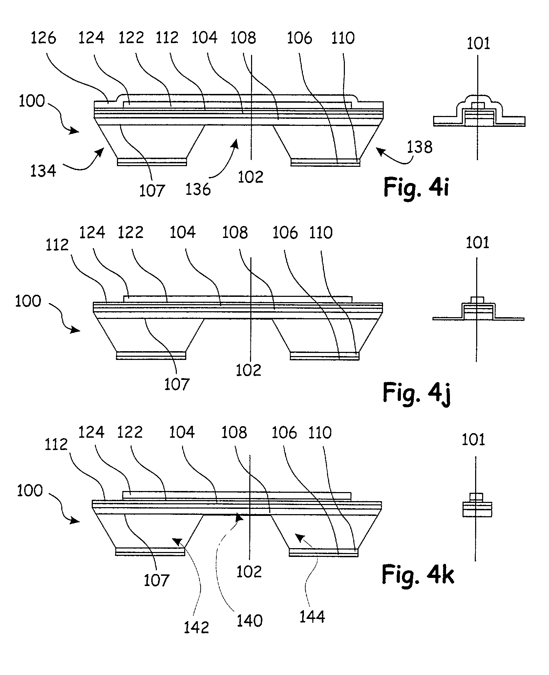

The flexibility of the flexible sections is achieved by reducing the wafer thickness at particular locations, such as the flexible sections 16, 18, 20 and/or 22 on the wafer 10, at which location flexibility is required so as to enable manoeuvrability of the circuit elements positioned on either side of the flexible sections relative to each other. A first manufacturing technique for obtaining the reduction of the wafer thickness is in the following described in greater detail with reference to figures 3a through 3m and a second manufacturing technique will be described in greater detail with reference to figures 4a through 4k.

Figure 3a through 3m show cross-sectional views of a section 50 of a wafer during a series of steps in a manufacturing process utilising boron diffusion techniques. Each of the figures 3a through 3m includes two cross-sectional views of the section 50 during one step. The first view on the left hand side of the figures is defined as the longitudinal cross-sectional view of the section 50 in a cut indicated by a first vertical line defined by reference numeral 51 shown on the right hand side figure. The second view on the right hand side of the figures is defined as the transversal cross-sectional view of the section 50 in a cut indicated by a second vertical line designated by reference numeral 52. The section 50 is an example of an implementation of a flexible element in this context to be construed as the initial basic element for obtaining a flexible element as described with reference to figures 1 and 2. Hence the section 50 may incorporate any number of flexible sections.

Initially silicon oxide layers 54 and 56 are grown onto both sides of a substrate 58 of silicon, as shown in figure 3a. The silicon oxide layers 54 and 56 have a thickness in the range from 4000 Å to 8000 Å, preferably a thickness of approximately 6000 Å. The growing of silicon oxide layers 54 and 56 are generally accomplished by a wet oxidation process.

A photo resist is deposited onto the upper silicon oxide layer 56. The photo resist is exposed through a mask defining areas to be etched on the upper silicon oxide layer 56 and upon development the photo resist is removed in the areas defined by the mask. Thus by applying and pattern a photo resist the silicon oxide layer 56 may be etched in any desired pattern. The particular etching of the silicon oxide layer 56 results in a longitudinal grove in the silicon oxide layer 56, as shown in figure 3b, transversely delimited by silicon oxide elements 60 and 62 of the silicon oxide layer 56. The etching is generally accomplished by immersing the wafer and thus the section 50 into diluted hydrofluoric acid, which etches the silicon oxide layers in areas not protected by the photo resist.

Additionally, photo resist is deposited onto the lower silicon oxide layer 54 before the wafer is immersed into the diluted hydrofluoric acid to protect it from the etching. Subsequently to etching of the wafer the photo resist is removed again.

The section 50 is then placed in a diffusion oven with solid boron nitride sources. In areas where the silicon oxide layer 56 is etched away during the previous etching step, the substrate 58 is being doped establishing a boron diffusion layer designated by reference numeral 64 and shown in figure 3c is achieved. The diffusion takes place at temperatures of approximately 1000°C for a few hours to obtain 1 to 10 µm deep doped regions in the substrate 58 having a boron content greater than 5·10¹⁹ atoms/cm³.

Subsequent to the doping of the substrate 58 the silicon oxide layers 54 and 56 are removed together with the boron glass generated in the oven by placing the section 50 into the diluted hydrofluoric acid. Thus, as shown in figure 3d, the section 50 now entirely comprises the boron diffusion layer 64.

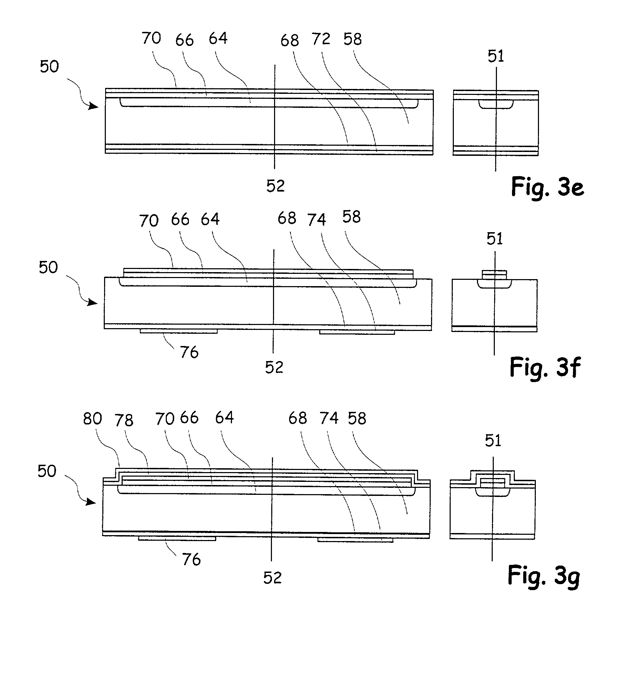

After removal of the silicon oxide layers 54 and 56 and the boron glass new silicon oxide layers 66 and 68 are grown on upper and lower surfaces of the substrate 58, as shown in figure 3e. The thickness of the new silicon oxide layers 66 and 68 is in a range from a few Å to several µm, preferably the thickness is approximately 3000 Å. Further, the silicon oxide layers are generally grown using wet oxidation process.

Silicon nitride layers 70 and 72 are grown on top of the new silicon oxide layers 66 and 68 using a low-pressure chemical vapour deposition (LPCVD) process. The thickness of the silicon nitride layers 70 and 72 on the outward facing surfaces of the new silicon oxide layers 66 and 68 is in a range from a few Å to 5000 Å, preferably the thickness is approximately 1200 Å. The new silicon oxide layers 66 and 68 and the silicon nitride layers 70 and 72 cover the substrate 58 and the boron diffusion layer 64.

Following the growing of the new silicon oxide layers 66 and 68 and the silicon nitride layers 70 and 72, a photo resist is deposited onto the lower surface of the section 50, that is the outer surface of the silicon nitride layer 72. The photo resist is exposed through a mask and developed so as to leave specific areas non-protected.

The mask utilised for defining the etching areas of lower surface of the section 50 defines solid regions of the final flexible section 50. The silicon nitride layer 72 is removed by a reactive ion etch process leaving only areas designated by reference numerals 74 and 76, as shown in figure 3f, and defining solid regions of the final flexible section 50.

Photo resist is further deposited onto the upper surface of the sections 50, that is the outer surface of the silicon nitride layer 70. The photo resist is as before exposed through a mask and developed so as to leave specific areas non-protected. In particular the mask applied to the upper surface of the section 50 ensures that photo resist is deposited substantially above the boron diffusion layer 64 thus protecting this area during the reactive ion etch process. The silicon nitride layer 70 and the silicon oxide layer 66 are removed by a reactive ion etch process leaving only areas protected by the photo resist, as shown in figure 3f.

Following the reactive ion etch process the photo resist is removed from upper and lower surfaces of the section 50 and an first adhesion layer 78 of chromium is evaporated onto the upper surface of the section 50. The first adhesion layer 78 generally has a thickness in a range from 50 to 150 Å, preferably the thickness is approximately 100 Å. Then a second adhesion layer 80 of gold is evaporated onto the upper surface of the section. The second adhesion layer 80 generally has a thickness in a range from 500 to 4000 Å, preferably the thickness is approximately 1000 Å.

Photo resist is now deposited on the outer surface of the second adhesion layer 80 exposed through a mask and developed defining regions of the final flexible section 50 to be electrically conductive. A few µm of metal is deposited in the defined regions, shown in figure 3h as an electrically conductive layer designated by reference numeral 82.

The conductive layer 82 may be implemented in any conductive material such as any metal materials compatible with the overall process for manufacturing a flexible element. The conductive material may be deposited by any means such as e-beam evaporation, sputtering and electroplating. Alternatively, a silicide or highly doped polysilicon allowing higher temperature processing steps than metal may be implemented as the conductive material.

The photo resist is removed from the upper surface of the second adhesion layer 80 and a few µm of nickel is electroplated onto the upper surface of the section 50, shown in figure 3i as a nickel layer designated by reference numeral 84. The nickel layer 84 will act as a protective layer against potassium hydroxide used in a subsequent processing step.

The wafer hence the section 50 is immersed into diluted hydrofluoric acid to remove the exposed areas of silicon oxide layer 68 on the lower surface the section 50 as shown in figure 3j. The wafer hence the section 50 is then immersed into potassium hydroxide to etch the remaining exposed areas of the substrate 58. The etching is continued until a thickness ensuring the flexibility of the final flexible structure 50 is reached. The etching process ceases as it reaches the boron diffusion layer 64 as shown in figure 3k.

The wafer hence the section 50 is then immersed into nitric acid to etch away the protective nickel layer 84 as shown in figure 3l.

Finally, the wafer hence the section 50 is immersed into Entreat® so as to etch away the second adhesion layer 80 of gold, and is subjected to plasma clean in oxygen converting the chromium in the first adhesion layer 78 to chromium oxide, which subsequently will evaporate. The final flexible section 50 that is shown in figure 3m having a flexible element 86 defined between the two rigid silicon substrate elements 88 and 90.

Figure 4a through 4k show cross-sectional views of a section 100 of a wafer during a series of steps in a manufacturing process utilising reactive ion etch techniques. As described with reference to figures 3a through 3m each of the figures 4a through 4k includes two cross-sectional views of the section 100 during one step. The first view on the left hand side of the figures is defined as the longitudinal cross-sectional view of the section 100 in a cut indicated by a first vertical line defined by reference numeral 101 shown on the right hand side figure. The second view on the right hand side of the figures is defined as the transversal cross-sectional view of the section 100 in a cut indicated by a second vertical line designated by reference numeral 102. Again the section 100 is an example of an implementation of a flexible element in this context to be construed as the initial basic element for obtaining a flexible element as described with reference to figures 1 and 2. Hence the section 100 may incorporate any number of flexible sections.

Initially silicon oxide layers 104 and 106 are grown onto both sides of a silicon on insulator substrate 108, as shown in figure 4a. The silicon on insulator substrate 108 incorporates an insulator layer 107 utilised for controlling a later etching process and determining the final flexibility of the flexible element. The thickness of the silicon oxide layers 104 and 106 is in a range from few Å to several µm, preferably the thickness is approximately 3000 Å. Further, the silicon oxide layers are generally grown using wet oxidation process.

Silicon nitride layers 110 and 112 are grown on top of the silicon oxide layers 104 and 106 using a low-pressure chemical vapour deposition (LPCVD) process. The thickness of the silicon nitride layers 110 and 112 on the outward facing surfaces of the silicon oxide layers 104 and 106 is in a range from a few Å to 5000 Å, preferably the thickness is approximately 1200 Å.

A photo resist is deposited onto the lower surface of the section 100, that is the outer surface of the silicon nitride layer 112. The photo resist is deposited, exposed through a mask and developed so as to leave specific areas non-protected.

The mask utilised for defining the etching areas of lower surface of the section 100 defines solid regions of the final flexible section 100. The silicon nitride layer 112 is removed by a reactive ion etch process leaving only areas designated by reference numerals 114 and 116, as shown in figure 4c, and defining solid regions of the final flexible section 100.

A photo resist is further deposited onto the upper surface of the sections 100, that is the outer surface of the silicon nitride layer 110. The photo resist is as before exposed through a mask and developed so as to leave specific areas non-protected. In particular the mask applied to the upper surface of the section 100 defines a dielectric region as well as desired flexible regions of the section 100. The reactive ion etching process is continued on the upper surface of the section 100 until a few µm of material has been removed from the upper section 100 and stops on the oxide layer in the silicon on insulator substrate. The reactive ion etching process leaves a longitudinal bar at the centre of the upper surface of the section 100, while etching away regions designated by reference numerals 118 and 120 shown in figure 4d.

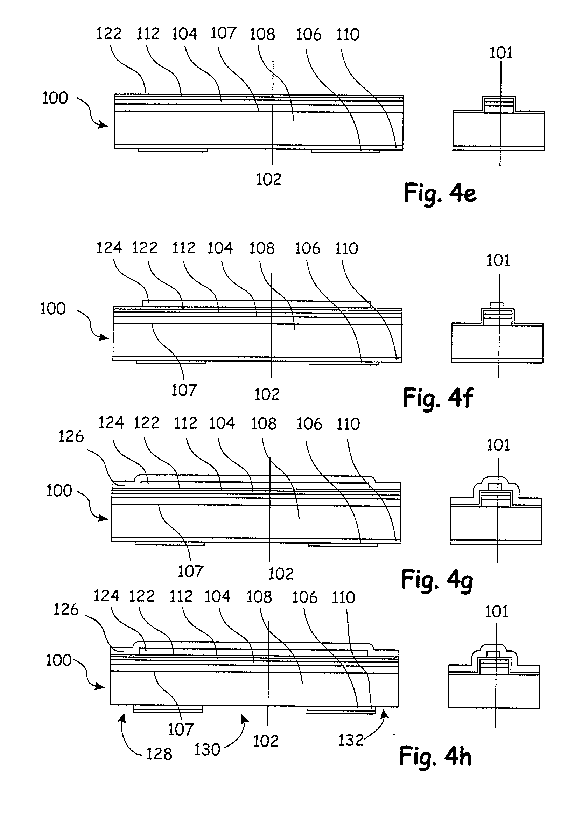

Following the reactive ion etch process the photo resist is removed from upper and lower surfaces of the section 100 and, as shown in figure 4e, a adhesion layer 122 comprising firstly a layer of chromium evaporated onto the upper surface of the section 100. The chromium layer 122 generally has a thickness in a range from 50 to 150 Å, preferably the thickness is approximately 100 Å. The adhesion layer 122 further comprising a gold layer evaporated onto the upper surface of the chromium layer. The gold layer generally has a thickness in a range from 500 to 4000 Å, preferably the thickness is approximately 1000 Å.

Photo resist is now deposited on the outer surface of the adhesion layer 122 exposed through a mask, and developed defining regions of the final flexible section 100 to be electrically conductive. A few µm of conductive material is deposited in the defined regions, shown in figure 4f as an electrically conductive layer designated by reference numeral 124.

The conductive layer 124 may be implemented in any conductive material such as any metal materials compatible with the overall process for manufacturing a flexible element. The conductive material may be deposited by any means such as e-beam evaporation, sputtering and electroplating. Alternatively, a silicide or highly doped polysilicon allowing higher temperature processing steps than metal may be implemented as the conductive material.

The photo resist is removed from the upper surface of the section 100 and a few µm of nickel is electroplated to the surface, shown in figure 4g as a nickel layer designated by reference numeral 126. The nickel layer 126 will act as a protective layer for the upper surface of the section 100 against potassium hydroxide used in a subsequent processing step. Further, by leaving the nickel layer 126 on the surface of the upper surface of the section 100 the nickel layer 126 may act as a protective layer for protecting the section 100 against corrosion or hazardous depositing on the section 100.

In an alternative embodiment of the processes as described with reference to either figures 3a to 3m or figures 4a to 4k an optical guide is established in dielectric layer so as to enable optical communication between the solid regions of the flexible element 50, 100. In a further alternative embodiment of the present invention a fluid conducting groove or tunnel is established within the substrate 50, 100 so as to enable fluid communication between the solid regions of the flexible element 50, 100. In a further alternative embodiment of the present invention the adhesion layer 122 receives a piezo electric layer so as to enable mechanical movement of the flexible section of the transmitting mechanical signal to the surroundings. In an additional alternative embodiment the adhesion layer 122 receives a combination of optical guide, fluid conducting groove or tunnel, piezo electric layer and an electric conductive layer.

The wafer hence the section 100 is immersed into diluted hydrofluoric acid to remove the exposed areas of silicon oxide layer 110 on the lower surface the section 100 as shown in figure 4h as regions designated by reference numerals 128, 130 and 132. The wafer hence the section 100 is then immersed into potassium hydroxide to etch the remaining exposed areas of the substrate 108. The etching is continued until a thickness ensuring the flexibility of the final flexible section 100 is reached. The etch ceases on the oxide layer in the silicon on insulator substrate. The removed regions are shown in figure 4i as reference numerals 134, 136 and 138.

The wafer hence the section 100 is then immersed into nitric acid to etch away the protective nickel layer 126 as shown in figure 4j.

Finally, the wafer hence the section 100 is immersed into Entreat® so as to etch away the gold layer of the adhesion layer 122 and is subjected to plasma clean in oxygen converting the chromium in the chromium layer of the adhesion layer 122 to chromium oxide, which subsequently will evaporate.

The final flexible section 100 is shown in figure 4k, and having a flexible element 140 defined between the two rigid silicon substrate elements 142 and 144.

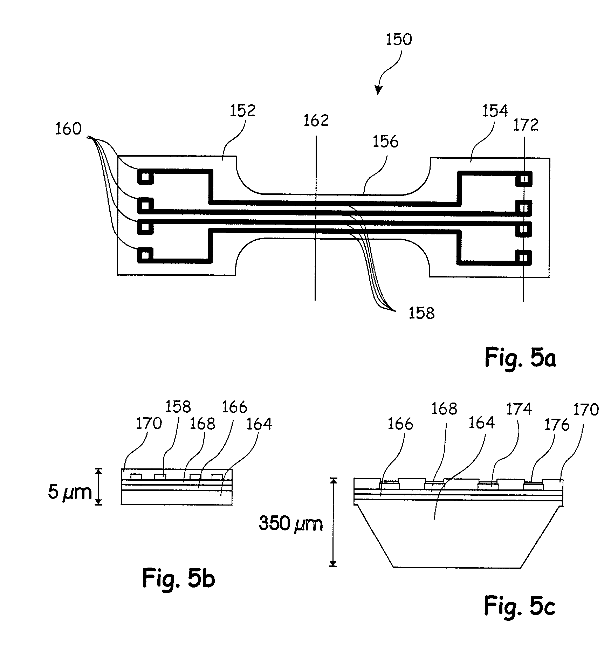

Figure 5a through 5c, show an example of a flexible element designated in its entirety by reference numeral 150. Figure 5a shows in a top view, the flexible element 150 comprising two rigid regions 152 and 154 on either side of a flexible centre section 156 connecting the two rigid regions 152 and 154 and enabling the two rigid regions 152 and 154 to be shifted relative to each other in three dimensions. The flexible element 150 further comprises on the top surface electrically conductive leads 158 for enabling electric communication between the two rigid regions 152 and 154. The conductive leads 158 may be implemented in any conductive material such as any metal materials compatible with the overall process for manufacturing a flexible element. The conductive material may be deposited by any means such as e-beam evaporation, sputtering and electroplating. Alternatively, a silicide or highly doped polysilicon allowing higher temperature processing steps than metal may be implemented as the conductive material.

In this example of the flexible element 150 the conductive leads 158 are terminated at each rigid region 152 and 154 in connection terminals 160. The conductive leads 158 may in an alternative embodiment be terminated directly into circuit elements or microsystems implemented in the rigid regions 152 and 154 or into circuit elements or microsystems mounted onto the rigid regions 152 and 154.

Figure 5b shows a first cross-sectional view of a cut in the flexible element 150, which cut is indicated in figure 5a as vertical line 162 in the flexible centre section 156. The flexible centre section 156 has an overall thickness in a range between 1 to 10 µm, preferably the thickness of the flexible centre section 156 is approximately 5 µm. The flexible centre section 156 comprises a substrate 164 provided with one or two insulating layers 166 and/or 168. The first insulating layers 166 and/or 168 may be a silicon oxide layer achieved by thermal diffusion or by a chemical vapour deposition (CVD) process and/or a silicon nitride layer achieved by CVD. However, the insulating layers 166 and/or 168 may in fact be any dielectric e.g. spin coated polymer type.

Above the conductive leads 158 a further or a multiple of second insulating layers 170 are deposited so as to insulate electrically and electro-magnetically the conductive leads 158 from the exterior environment. Further the second insulating layer or layers 170 protect the conductive leads 158 from corroding. The second insulating layer or layers 170 may as described with reference to the first insulating layers 166 and 168 be any dielectric materials deposited.

Figure 5c, shows a second cross-sectional view of a cut in the flexible element 150, which cut is indicated in figure 5a as vertical line 172 in the rigid region 154. The rigid regions 154 and 156 have an overall thickness in a range between 100 to 1000 µm, typically in a range between 300 to 700 µm and preferably the thickness is approximately 350 µm.

The terminals 160 comprise conductive pads 174 connecting to the conductive leads 158 and a bond pad 176 added on top of the conductive pads 174. The bond pad 176 is deposited in the openings of the terminals so as to allow a microsystem to be connected electrically to the conductive pads 174.

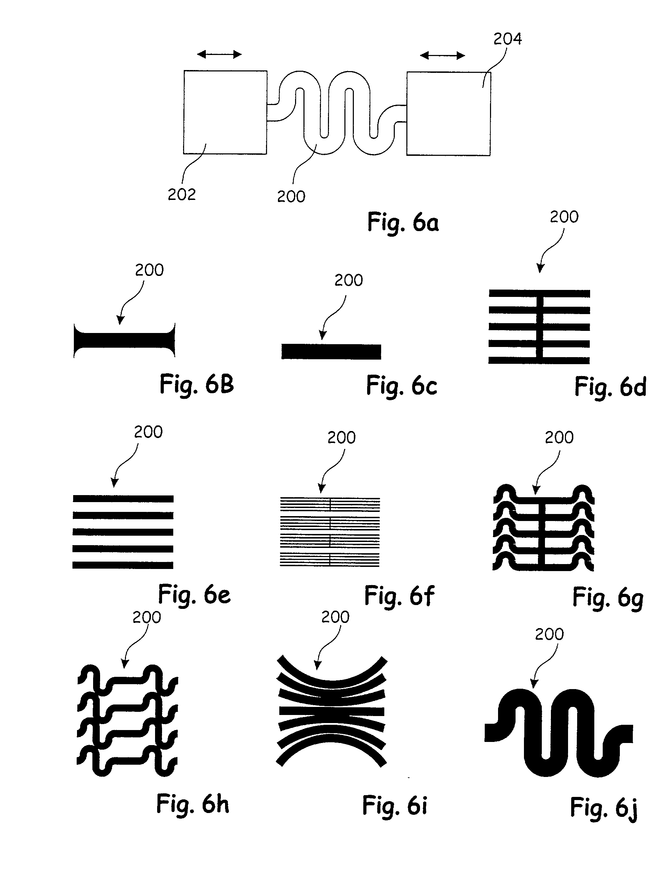

Figures 6a through 6j show a wide variety of alternative embodiments of flexible centre sections 200 connecting at each end to rigid regions 202 and 204. The flexible centre sections 200 enable shifting the rigid regions 202 and 204 in three dimensions relative to one another.

Each embodiment of the flexible centre sections 200 shown in figures 6a through 6j serve a particular design criterion. The each embodiment may appropriately ensure the highest mechanical stability of the substrate. The embodiments comprise straight single beams, as shown in figures 6b and 6c, plurality of straight parallel beams, as shown in figures 6d to 6f, plurality of straight parallel beams having curved or corrugated distal ends, as shown in figures 6g and 6h, and meandered type structure of beams, as shown in figure 6i. The meandered type structure of beams allows the flexible element to be elongated dynamically or twisted and turned statically so as to enable for vertical and/or horizontal alignment between the two rigid regions 202 and 204.

Finally figure 6j, shows a single corrugated beam allowing the flexible element to be elongated dynamically or twisted and turned statically so as to enable for vertical and/or horizontal alignment between the two rigid regions 202 and 204.

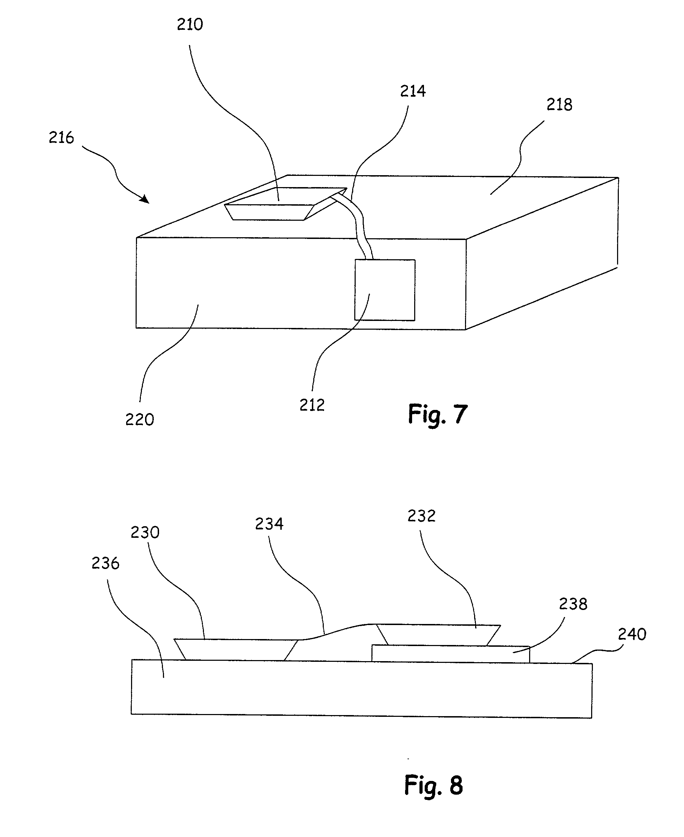

Figure 7, shows a first utilisation of the flexible element comprising two rigid regions 210 and 212 connected to one another by a flexible centre section 212. The flexible element is positioned on a block 216 having the first rigid region 210 of the flexible element positioned on a horizontal surface 218 of the block 216, and the second rigid region 212 positioned on a vertical surface 220 of the block. The flexible centre section 214 thus twists twice by 90° in to planes.

Figure 8, shows second utilisation of the flexible element comprising as before two rigid regions 230 and 232 connected to one another by a flexible centre section 234. The flexible element is positioned on a block 236 having an elevated surface area 238 supporting the second rigid region 232 and having a non-elevated surface area 240 supporting the first rigid region 230. The flexible centre section 234 thus twist twice by 90 ° in one plane.

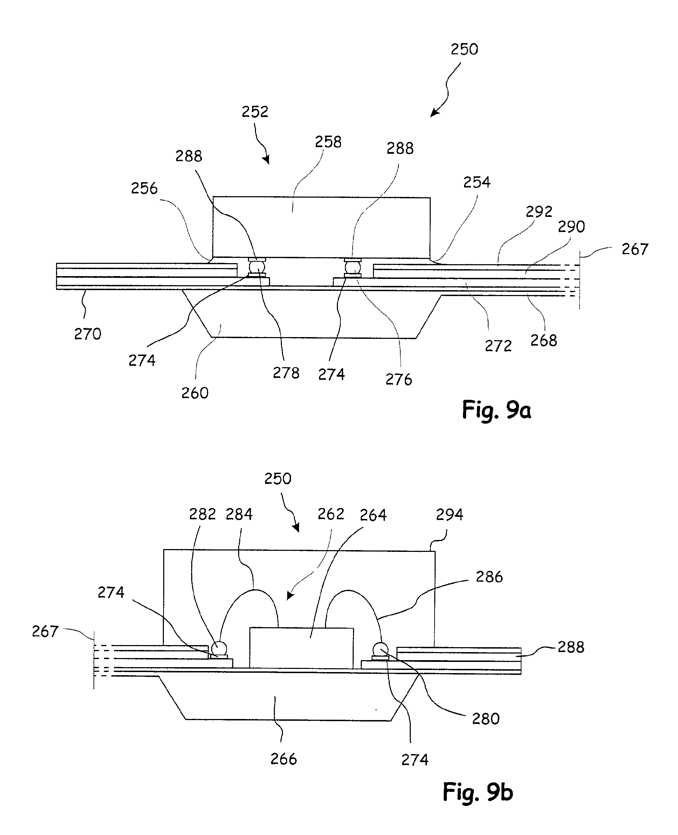

Figures 9a and 9b, show flexible element designated in its entirety by reference numeral 250. The figures show two alternative mounting implementations on the flexible element 250. Figure 9a shows a flip chip bonded first circuit element 258 positioned on a first rigid region 260 with underfill 254 and 256 covering the entire gap between the circuit element 258 and rigid region 260. Figure 9b shows a wire-bonded die 262 having a second circuit element 264 positioned on a second rigid region 266.

A vertical line designated by reference numeral 267 in both figures 9a and 9b indicates a connection point of the flexible element 250 between the two figures. The first rigid region 260 is integrally connected to the second rigid section 266 by a flexible centre section 268. The thickness of the flexible centre section 268 is determined by controlling the above with reference to figures 3 and 4 described manufacturing processes.

The flexible element 250 comprises a first dielectric layer 270 grown on an upper surface of a substrate constituted by the flexible centre section 268 and the first and second rigid regions 260 and 266 respectively.

The flexible element 250 further comprises conductive leads 272 connecting the first and the second circuit elements 258 and 264. In proximity of each of the distal ends of the conductive leads 272 bonding pads 274 may be positioned on the outward-facing surface of the conductive leads 272 for receiving gold studs 276, 278, 280 and 282 electrically connected to the bonding pads 274 and enabling electrical communication between the first and the second circuit element. The gold studs 280 and 282 are connected to the second circuit element through wires 284 and 286 and the gold studs 276 and 278 are connected to the first circuit element through further bonding pads 288.

A second dielectric layer 290 is deposited on top of the conductive leads 272 and lastly the upper surface of the flexible element 250 is coated with a protective metal coating 292 such as a gold, silver, aluminium or nickel layer.

The underfill 254, 256 is applied to encapsulate bonding pads on the flip chip bonded die 252. The underfill material may be epoxy or another polymer. Together with the protective metal coating 292 the underfill 254, 256 provides the possibility of protecting the conductive parts of the system from the surroundings. The combination of the underfill 254, 256 providing extensive diffusion distances in a direction parallel to the upper surface of the system and the protective metal coating 292 supporting the underfill 254, 256 by providing extensive resistance for diffusion in a direction perpendicular to the upper surface of the system gives an unique protection of the system. Further, the combination may provide environmental compatibility between the surroundings and the flexible element 250. In this context environmental compatibility should be construed as chemical, mechanical, electrical and magnetical compatibility both from the surrounding to the flexible element 250 but also from the flexible element 250 to the surroundings.

Typically moisture will have the ability to penetrate a polymer rendering it necessary to implement a relatively thick layer if the underlying material is to be protected. By applying a protective metal coating 292 a thin effective barrier is achieved. The underfill 254 will eventually allow moisture to penetrate from the surroundings to the gold studs 276, however, the diffusion length through the underfill 254 is relatively long since the moisture has to penetrate in a direction parallel to the upper surface of the system. The diffusion length through the metal barrier will be on the order of microns, whereas through the polymer on the order of 100 microns. In an alternative embodiment the protective solution would be to encapsulate the die region with a glass capsule.

As shown in figure 9b the wire-bonded die 262 may be further protected by a shielding 294. The shielding 294 may be implemented in a material, which is compatible with a particular application. For example the shielding 294 may be implemented in a glass material so as to achieve bio-compatibility. However, for other applications the shielding 294 may be a multi-layered material, in which each layer may have a particular function for establishing compatibility. That is for example, a glass layer for establishing insulating and bio-compatible layer, aluminium foil for providing electro-magnetic shielding from external noise sources. When applying a thin protective coating it is advantageous to have a planar surface, since the planar surface provides a smooth basis for receiving the protective coating and ensures that no parts are left unprotected. The integration of the flexible centre section 268 in a microsystem makes it possible to transfer an optical or electrical signal away from a critical region where the microsystem is exposed to a harsh environment while maintaining a planar surface.

In an alternative embodiment, however, the shielding 294 may be implemented in a flexible structure so as to encapsulate the wire-bonded die 262.

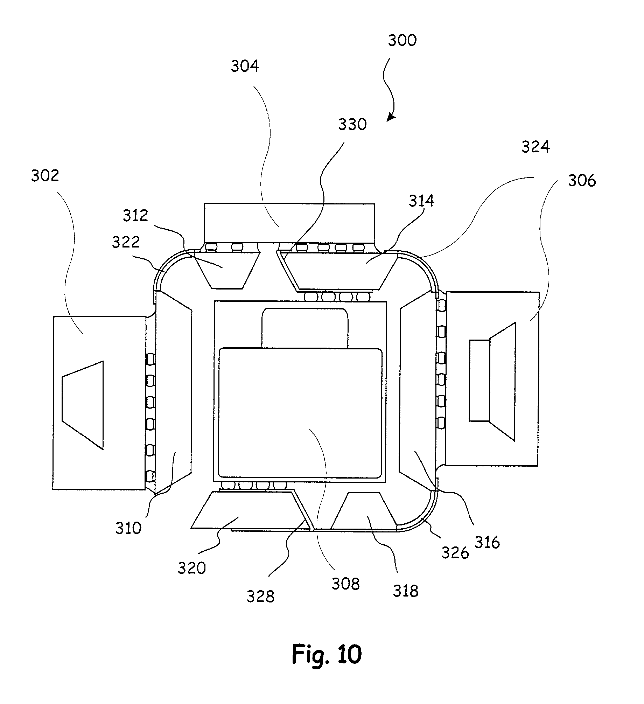

Figure 10 shows a further utilisation of the flexible element designated in its entirety by reference numeral 300. The flexible element 300 constitutes a hearing aid comprising a microphone section 302, an amplifier section 304, and a load speaker section 306 folded about a battery section 308. The sections 302, 304, 306 and 308 are mounted on a unitary flexible substrate having rigid regions 310, 312, 314, 316, 318 and 320 integrally connected by flexible substrate sections 322, 324 and 326. The figure additionally shows feed-through units 328 and 330 connecting the upper and lower surfaces of the rigid regions 314 and 320.

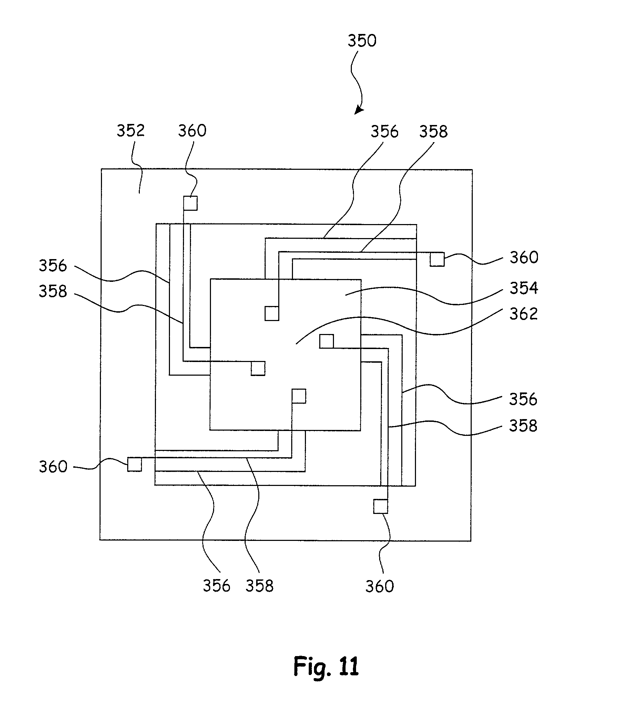

Figure 11 shows a mechanical stress-decoupling set-up designated in its entirety by reference numeral 350. The mechanical stress-decoupling set-up 350 comprises a solid frame 352 and a solid element 354, and comprises plurality of thin flexible silicon beams 356 interconnecting the solid frame 352 and solid element 354 so as to enable free movement of the solid element 354 relative to the solid frame 352. The silicon beams 356 each carry a conductive channel 358 for enabling communication between devices 360 situated on the solid frame 352 and devices 362 situated on the solid element 354. The conductive channel 358 may in a first embodiment of the present invention enable optical communication between the devices 360 and 362, in a second embodiment of the present invention enable electrical communication between devices 360 and 362, in a third embodiment of the present invention enable fluid communication between devices 360 and 362, and in a fourth embodiment of the present invention enable a combination of electrical, optical or fluid communication between devices 360 and 362.

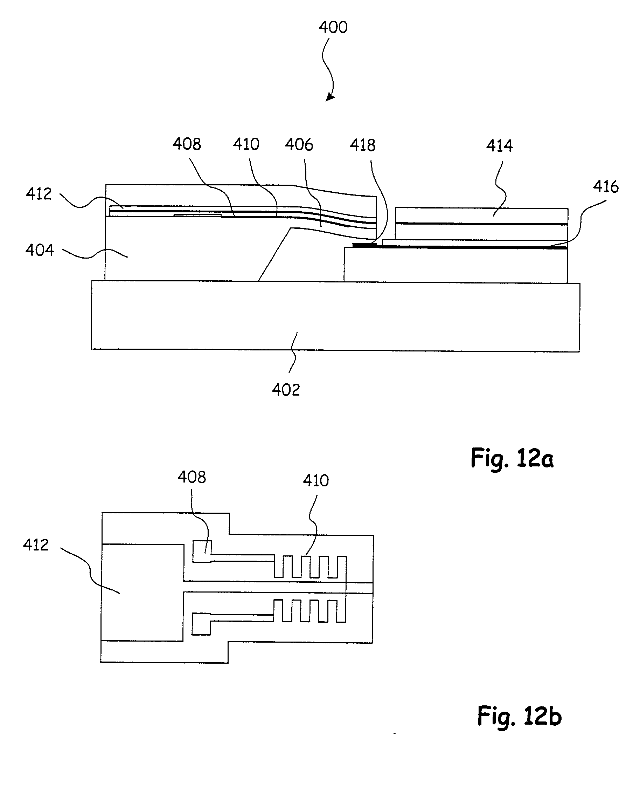

Figures 12a and 12b show two cross sectional views of an aligning module designated in its entirety by reference numeral 400. A mounting substrate 402 supports a solid silicon section 404 having a thin flexible section 406 protruding from one edge of the section 404. The section 404 carries electrically conductive leads 408 on its upper surface connecting to a resistor 410 integrated into the thin flexible section 406. Additionally, the upper surface of the section 404 incorporates a first optical wave-guide 412. The mounting substrate 402 further supports a second optical wave-guide 414 positioned on a support including an electro-static actuator 416. The first optical wave-guide 412 may be defined in the dielectric layers deposited during the manufacturing process. However, the first optical wave-guide 412 in one embodiment of the present invention may be defined as a core layer of dielectric having a high refractive index sandwiched between two dielectric layers having a lower refractive index. The second optical wave-guide 414 may be implemented as general state of the art optical wave-guides.

The aligning module 400 is used for pick tailing optics. The signal from the first optical wave-guide 412 has to be guided to the second optical wave-guide 414. In the embodiment shown in figures 12a and 12b a thermal actuation or electrostatic actuation is used to achieve the right position of the optical signal. The thermal actuation is accomplished by leading a current through the resistor 410 causing the temperature of the surrounding material to increase thus expanding. The electrostatic actuation is accomplished by the electro-static actuator 416 having an electrode 418 providing a first electro-static potential inducing a deflection of the thin flexible section 406 having a second electro-static potential. The second electrostatic potential is provided by the resistor 410. Alternatively, the electro-stactic actuator 416 may be replaced by an electro-magnetic actuator.

Initially the integrated optics 412 and the optical wave-guide 414 are aligned within a few microns and fixed to the mounting substrate 402. By thermal actuation, electrostatic actuation or electro-magnetic actuation the first optical wave-guide 412 and the second optical wave-guide 414 will be aligned with sub-micron accuracy before the final encapsulation that fix the first optical wave-guide 412 and the second optical wave-guide 414 in the aligned position.

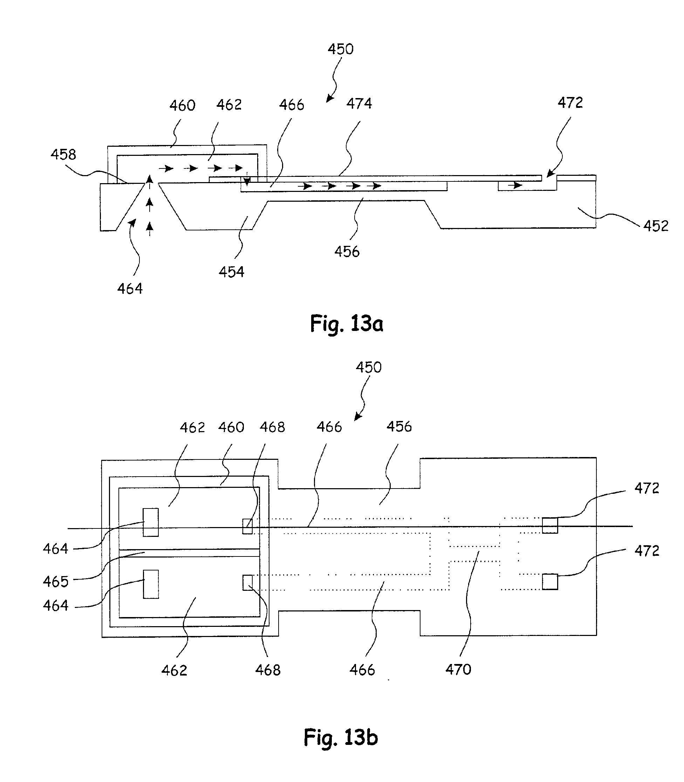

Figures 13a and 13b show two cross sectional views of a flexible structure designated in its entirety by reference numeral 450. The flexible structure 450 might be manufactured as the section 100 described with reference to figures 4a to 4k. The flexible structure 450 comprises two rigid solid sections 452 and 454 interconnected by a thin flexible section 456. On the upper surface 458 of the rigid section 452 supports a cover 460 such as a hollow glass capsule, which cover 460 provides a first set of channels 462 between the upper surface 452 and the cover 460. The rigid section 452 comprises passages 464 allowing fluid to flow through the rigid section 452 to the first channel 462. The first channel 462 may be divided into two separate channels by a separation wall 465. The separation wall 465 may be utilised for separating two fluids to transfer to the rigid section 452 thus delaying any mixture of the fluids until their reach the rigid section 452.

Second channels 466 defined in the thin flexible section 456 enable fluid to flow between the two rigid sections 452 and 454. The fluid may enter from the first channels 462 to the second channels 466 through openings 468. The fluids flow to the rigid section 452 were the second channels 466 merge into a single third channel 470 thus mixing the fluids. Passages 472 allow the fluids to escape the rigid section 452. The second channels 466 are covered by a protective layer 474 such as film or plate.

Subsequent to defining the thin flexible section 456 during the manufacturing process as described above recesses are etched in the surface of the wafer either by a wet etch in KOH or a dry etch by reactive ion etching to establish the second channels 466. The recesses are filled with a sacrificial layer that can be a resist or a silicon oxide and finally the wafer will be covered with a thin film constituting the protective layer 474. The protective layer 474 may be a spin coated polymer type that is later protected for the final KOH etch, or it can be electroplated nickel. The flexible structures will then be realised with a KOH etch. The sacrificial layer is then removed by a selective etch (resist with acetone, oxide with BHF).

The thin flexible section 456 will be used for transport of fluid while in the solid regions 452 and 454 mixing and reactions can take place.

## Claims

1. Method for producing a unitary flexible microelement from a supporting wafer, said unitary flexible microelement defining a supporting body having a solid region, a flexible region, an upper surface and a lower surface, and said method comprising the following steps of:
(a) defining thickness of said flexible region,
(b) growing an upper insulating layer to said upper surface substantially covering a predefined area and growing a lower insulating layer to said lower surface substantially covering said solid region so as to protect said solid region of said supporting body against etching,
(c) defining a conductive layer on said predefined area of said upper surface, and depositing a protective layer on said upper surface covering said conductive layer so as to protect said conductive layer against etching, and
(d) etching said lower surface until said etching reaches said thickness of said flexible region so as to establish said flexible region and to establish said solid region.

2. Method according to claim 1, wherein said conductive layer enabling fluid, optical, mechanical or electrical communication or any combination thereof across said flexible region.

3. Method according to any of claims 1 or 2, wherein said protective layer comprises nickel (Ni) electroplated on said upper surface.

4. Method according to any of claims 1 to 3, wherein said solid region comprising a range of solid sections and wherein said flexible region comprising a range of flexible sections interconnecting said solid sections so as to establish a unitary flexible microsystem, and/or wherein each of said range of solid sections carry application specific integrated circuits (ASIC), integrated circuits, transducers, sensors, power units, actuators, micro electro-mechanical systems (MEMS) or any combination thereof.

5. Method according to any of claims 1 to 4 further comprising depositing a conform coating layer surrounding said entire unitary flexible microelement so as to provide a bio-compatible protective layer.

6. Method according to any of claims 1 to 5, wherein said method is undertaken at wafer level.

7. An unitary flexible microelement foldable in three-dimensional directions and comprising:
(a) a supporting body defining a first solid region and a flexible region extending outwardly in coplanar relationship from said solid region from upper surface of said supporting body,
(b) an first insulating layer grown on said upper surface of said supporting body,
(c) a conductive layer deposited on said insulating layer and communicating between said solid region and said flexible region,
(d) an second insulating layer deposited on said conductive lead insulating said conductive lead from surroundings, and
(e) pads connecting to distally positions of said conductive layer, said pads accessible through said second insulating layer from surroundings.

8. An unitary flexible microelement according to claim 7 further comprising a second solid region integrally connecting to said first solid region through distal end of said flexible region in coplanar relationship to said first solid body and said flexible region, and/or further comprising circuitry connecting to said pads and positioned above said first and/or second solid regions, said circuitry being implemented as application specific integrated circuits, integrated circuits, sensors, actuators, tranducers, micro electro-mechanical systems (MEMS) or combinations thereof, and wherein preferably said circuitry is flip chip bonded and protected in a direction parallel to said upper surface of said supporting body by an underfill positioned between said flip chip circuitry and said upper surface and protected in a direction perpendicular to said upper surface of said supporting body by a protective metal coating positioned on parts of said upper surface so as to provide protection against deterioration, and/or further comprising a conform coating layer surrounding the entire unitary flexible microelement so as to provide a bio-compatible protective layer.

9. An unitary flexible microsystem foldable in three-dimensional directions and comprising:
(a) a supporting body defining a first plurality of solid regions and a second plurality of flexible regions integrally connecting in coplanar relationship said first plurality of solid regions,
(b) a third plurality of conductive leads positioned on said second plurality of flexible regions and connecting said first plurality of solid regions,
(c) a fourth plurality of pads distally positioned on each of said third plurality of conductive leads and having a stud positioned above each of said fourth plurality of pads,
(d) a fifth plurality of circuitry positioned on said first plurality of solid regions connecting to said fourth plurality of pads.

10. An unitary mechanical stress-decoupling system comprising a rigid frame, a rigid element, a plurality of flexible beams integrally connecting said rigid frame and said rigid element so as to provide a stress-decoupling between said rigid frame and said rigid element.

11. An unitary mechanical stress-decoupling system according to claims 10, wherein said system is produced utilising a method as described with reference to any of the claims 1 to 6.

12. An unitary aligning module for aligning a first optical wave-guide and a second optical wave-guide and comprising a substrate supporting an unitary flexible microelement comprising a supporting body defining a first solid region and a flexible region extending outwardly in coplanar relationship from said solid region from upper surface of said supporting body and said unitary flexible microelement supporting said first optical wave-guide, and said substrate further supporting a deflection actuator having an upper surface supporting said second optical wave-guide and said deflection actuator controlling deflection of said flexible region so as to position said first optical wave-guide and said second optical wave-guide in alignment and wherein preferably said deflection actuator generating an electro-static, an electro-magnetic or a magnetic force for deflecting said flexible region and wherein preferably said unitary flexible microelement further comprises a conductive layer connecting to a resistor providing a thermal actuation of said flexible region.

13. A unitary flexible microelement for communicating fluid and comprising a first rigid part defining a first input passage and a first output passage communicating said fluid, a second rigid part defining a second input passage and a second output passage communicating said fluid, a flexible part interconnecting said first rigid part and said second rigid part and having a channel receiving said fluid from said first output passage and transporting said fluid to said second input passage, and a protective layer covering at least parts of upper surface of said unitary flexible microelement, said unitary flexible microelement preferably manufactured at wafer level in accordance with said method according to any of claims 1 to 6.
